# EUROPEAN PATENT APPLICATION

(11) **EP 2 704 203 A2**
(43) Date of publication of application: **05.03.2014**
(21) Application number: 13181237.2
(22) Date of filing: 21.08.2013
(51) Int. Cl.: H01L 31/0224, H01L 31/0296, H01L 31/0392, H01L 31/073

(54) **Use of an inert graphite layer in a back contact of a photovoltaic cell**

(30) Priority: 31.08.2012 US 201213601022
(71) Applicant: PrimeStar Solar, Inc, Arvada, CO 80004 (US)
(72) Inventor: Clark, Laura Anne, Arvada, CO Colorado 80004 (US); Lucas, Tammy Jane, Arvada, CO Colorado 80004 (US); Metzger, Wyatt Keith, Arvada, CO Colorado 80004 (US)
(74) Representative: Picker, Madeline Margaret

(57) **Abstract**

Photovoltaic devices 10 are provided that include a transparent superstrate 12; a transparent conductive oxide 14 on the transparent superstrate; an n-type window layer 18 on the transparent superstrate; a p-type absorber layer 20 on the n-type window layer; and an inert conductive paste layer 23 on the back surface of the p-type absorber layer. The p-type absorber layer 20 includes cadmium telluride, and defines a back surface positioned opposite from the n-type window layer 18 that is tellurium enriched. The inert conductive paste layer 23 is substantially free from an acid or acid generator. Methods are also generally provided of forming such a back contact.

## Description

The subject matter disclosed herein relates generally to photovoltaic devices, particularly cadmium telluride based photovoltaic devices, having an inert graphite layer forming part of the back contact, along with methods of their manufacture.

Thin film photovoltaic (PV) modules (also referred to as "solar panels") based on cadmium telluride (CdTe) paired with cadmium sulfide (CdS) as the photo-reactive components are gaining wide acceptance and interest in the industry. CdTe is a semiconductor material having characteristics particularly suited for conversion of solar energy to electricity. For example, CdTe has an energy bandgap of about 1.45 eV, which enables it to convert more energy from the solar spectrum as compared to lower bandgap semiconductor materials historically used in solar cell applications (e.g., about 1.1 eV for silicon). Also, CdTe converts radiation energy in lower or diffuse light conditions as compared to the lower bandgap materials and, thus, has a longer effective conversion time over the course of a day or in cloudy conditions as compared to other conventional materials. The junction of the n-type layer and the p-type absorber layer is generally responsible for the generation of electric potential and electric current when the CdTe PV module is exposed to light energy, such as sunlight. Specifically, the cadmium telluride (CdTe) layer and the cadmium sulfide (CdS) form a p-n heterojunction, where the CdTe layer acts as a p-type absorber layer (i.e., an electron accepting layer) and the CdS layer acts as an n-type layer (i.e., an electron donating layer).

A transparent conductive oxide ("TCO") layer is commonly used between the window glass and the junction forming layers. This TCO layer provides the front electrical contact on one side of the device and is used to collect and carry the electrical charge produced by the cell. Conversely, a back contact layer is provided on the opposite side of the junction forming layers and is used as the opposite contact of the cell. This back contact layer is adjacent to the p-type absorber layer, such as the cadmium telluride layer in a CdTe PV device.

Due to the high work function of CdTe, conventional metal back contacts are not generally viewed as being suitable. Instead, graphite pastes (either undoped or doped, for example with copper or mercury) are widely used as a back contact for CdTe PV cells. However, these graphite-paste back contacts tend to degrade significantly over time, as can be shown via accelerated lifetime testing. This degradation typically manifests itself as a decrease over time in fill factor (FF) and/or open circuit voltage (V_{OC}). The fill factor degradation is typically driven by a decrease in shunt resistance (Rₛₕ) and an increase in the series resistance (R_{OC}) over time. The degradation of the back contact electrodes undesirably leads to degradation of the solar cell efficiency, on a long-term basis.

It would therefore be desirable to provide a Cu-containing back contact electrode for a CdTe PV cell, which exhibits less degradation over the lifetime of the PV cell.

Aspects and advantages of the invention will be set forth in part in the following description, or may be obvious from the description, or may be learned through practice of the invention.

Photovoltaic devices are generally provided, in one embodiment, that include a transparent superstrate; a transparent conductive oxide on the transparent superstrate; an n-type window layer on the transparent superstrate; a p-type absorber layer on the n-type window layer; and an inert conductive paste layer on the back surface of the p-type absorber layer. The p-type absorber layer includes cadmium telluride, and defines a back surface positioned opposite from the n-type window layer that is tellurium enriched. The inert conductive paste layer is substantially free from an acid or acid generator.

Methods are also generally provided of forming a back contact onto an exposed surface of a p-type absorber layer (including cadmium telluride) of a p-n junction in the manufacture of a thin film photovoltaic device. In one embodiment, the method includes: enriching the exposed surface with tellurium; forming an inert conductive paste layer onto the exposed surface; and, applying a metal layer onto the inert conductive paste layer.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

A full and enabling disclosure of the present invention, including the best mode thereof, directed to one of ordinary skill in the art, is set forth in the specification, which makes reference to the appended figures, in which:
Fig. 1 shows a general schematic of a cross-sectional view of an exemplary cadmium telluride thin film photovoltaic device according to one embodiment of the present invention; and,
Fig. 2 shows another cross-sectional view of the exemplary cadmium telluride thin film photovoltaic device shown in Fig. 1 prior to forming a tellurium enriched region;

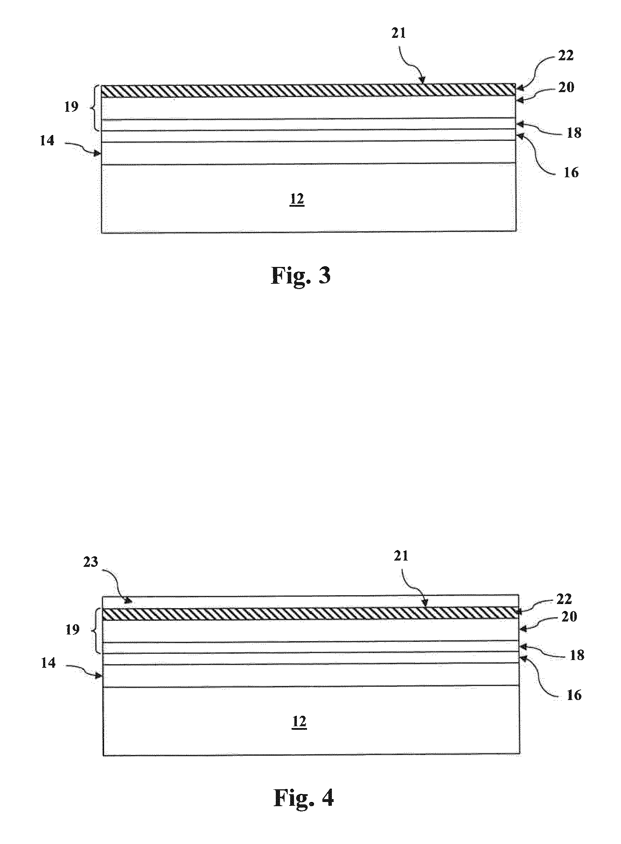

Fig. 3 shows a cross-sectional view of the exemplary cadmium telluride thin film photovoltaic device shown in Fig. 2 after forming a tellurium enriched region; and,
Fig. 4 shows a cross-sectional view of the exemplary cadmium telluride thin film photovoltaic device shown in Fig. 3 after formation of an inert graphite layer during formation of the back contact.

Repeat use of reference characters in the present specification and drawings is intended to represent the same or analogous features or elements.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

In the present disclosure, when a layer is being described as "on" or "over" another layer or substrate, it is to be understood that the layers can either be directly contacting each other or have another layer or feature between the layers. Thus, these terms are simply describing the relative position of the layers to each other and do not necessarily mean "on top of" since the relative position above or below depends upon the orientation of the device to the viewer. Additionally, although the invention is not limited to any particular film thickness, the term "thin" describing any film layers of the photovoltaic device generally refers to the film layer having a thickness less than about 10 micrometers ("microns" or "µm").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

Chemical elements are discussed in the present disclosure using their common chemical abbreviation, such as commonly found on a periodic table of elements. For example, hydrogen is represented by its common chemical abbreviation H; helium is represented by its common chemical abbreviation He; and so forth.

Photovoltaic devices are generally provided having an inert conductive paste layer (e.g., inert graphite layer) forming at least part of the back contact, along with their methods of manufacture. Such an inert conductive paste layer is particularly suitable for use with a tellurium enriched surface on a p-type absorber layer that includes cadmium telluride. In particular, the inert conductive paste layer is substantially free from a chemically active material that could alter the stoichiometry and/or chemical composition of the tellurium enriched surface (e.g., substantially free from a chemically active graphite), such as an acid generator.

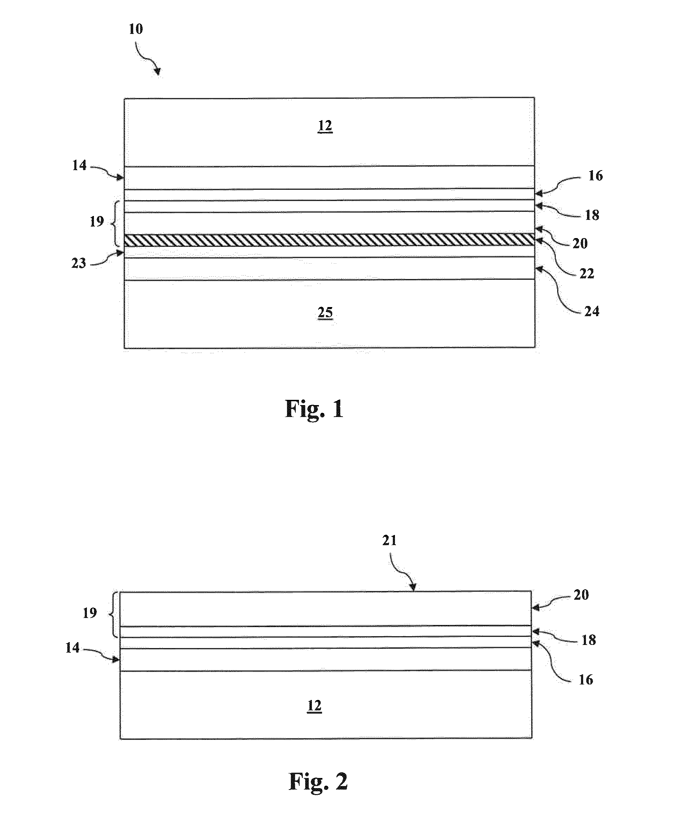

Fig. 1 shows a cross-section of an exemplary cadmium telluride based thin-film photovoltaic device 10. The device 10 is shown including a transparent substrate 12 (e.g., a glass substrate), a transparent conductive oxide (TCO) layer 14, a resistive transparent buffer layer 16, an n-type layer 18 (e.g., a cadmium sulfide layer), a p-type absorber layer 20 (e.g., a cadmium telluride layer), an inert conductive paste layer 23, and a metal contact layer 24. The n-type layer 18 and the p-type absorber layer 20 generally form a p-n junction 19 in the device 10.

During its manufacture, the exposed surface 21 of the p-type absorber layer 20 (prior to applying or forming the inert conductive paste layer 23 and/or the metal contact layer 24 thereon) can be enriched with tellurium form a Te-enriched region 22 within the p-type absorber layer 20. For example, the Te-enriched region 22 can have an atomic ratio of tellurium to cadmium of greater than about 2 (e.g., about greater than about 10). In certain embodiments, the tellurium-enriched region 22 formed has a thickness of about 10 nanometers to about 1000 nanometers.

The inert conductive paste layer can then be formed on (e.g., directly on) the tellurium enriched region 22 by application of a conductive paste followed by curing.

The conductive paste utilized to form the conductive paste layer 23 can generally include a conductive material, a solvent system, and a polymeric binder. In one particular embodiment, all of these materials (i.e., the conductive material, the solvent system, or the polymeric binder) are substantially free from an acid or an acid generator. Likewise, the conductive paste can further be substantially free from any acid or an acid generator as a separate component of the conductive paste. As such, the inert conductive paste layer will not substantially etch and/or alter the stoichiometry of the surface 21 (e.g., the tellurium enriched region 22).

The conductive material can be any material with a work function or electron affinity that closely matches that of CdTe. Since the work function of CdTe is about 5.5 eV, the desired material should have a work function greater than 4 eV. Additionally, the conductivity of this material should be greater than 1x10² Ω⁻¹m⁻¹. Some examples of materials that fall into the work function and conductivity parameters and that are known to perform well for CdTe include graphite carbon, Ni and its compounds, Mo and its compounds, Zn and its compounds, and Ti and its compounds, Tc and its compounds, Cr and its compounds. As such, in one particular embodiment, the conductive material can include at least one of graphite carbon or a metallic conductive material (e.g., Ni, Mo, Zn, Ti, Tc, Cr, or alloys, or organic derivatives thereof).

The polymeric binder in the conductive paste layer 23 generally provides a base material to secure the conductive material within the resulting device 10 and can act as an adhesive layer between the metal contact layer 24 and the p-type absorber layer 20. In one particular embodiment, the polymeric binder is a chlorinated polymeric binder or another halogenated polymer binder. The polymeric binder can generally include at least one organic polymer (i.e., containing a carbon backbone) or a combination of polymers forming a polymer system. As used herein, the term "polymer" generally includes, but is not limited to, homopolymers; copolymers, such as, for example, block, graft, random and alternating copolymers; and terpolymers; and blends and modifications thereof. Furthermore, unless otherwise specifically limited, the term "polymer" shall include all possible geometrical configurations of the material. These configurations include, but are not limited to isotactic, syndiotactic, and random symmetries.

In one embodiment, the conductive paste can be applied as a dry powder to the surface 21. In alternative embodiments, a solvent system can be utilized in the conductive paste, and can include at least one solvent that is configured to help apply the polymeric binder and/or the conductive material onto the surface 21 of the p-type absorber layer 20 during processing. As such, the particular solvent(s) can be selected based on the particular composition of the polymeric binder and/or the conductive material utilized in the conductive paste. The solvent can be substantially removed after applying the conductive paste to the surface 21 during subsequent processing (e.g,. during curing) such that the resulting device 10 is substantially free from the solvent. Suitable solvents can include, but are not limited to dimethyl succinate, dimethyl glutarate, or mixtures thereof. In one particular embodiment, the solvent system includes at least one chlorinated solvent.

The conductive paste can be applied onto the surface 21 of the p-type absorber layer during processing of the device 10 by any suitable method for spreading the blend or paste, such as screen printing, spraying or by a "doctor" blade. After the application of the conductive paste to the p-type absorber layer 20, the conductive paste can be cured to convert the conductive paste into the conductive paste layer 23. Such a curing process can evaporate the solvent system present in the as-applied conductive paste and/or crosslink the polymeric binder to secure and/or bond the conductive paste layer 23 on the surface 21.

The conductive paste layer 23 can generally provide improved adhesion to and/or contact between the surface 21 of the p-type absorber layer 20 and the metal contact layer 24. Additionally, by being substantially free from a chemically active material (e.g., an acid or acid generator), the device 10 can exhibit increased initial performance and increased long-term stability, including decreased delamination between the p-type absorber layer 20 and the metal contact layer 24. Additionally, the conductive paste layer 23 can fill any pinholes in the p-type absorber layer 20, to inhibit shunting of the device 10.

Such an inert conductive paste layer 23 can be formed, in one particular embodiment, by applying a paste onto the surface 21 of the p-type absorber layer 20. The paste can include, in one particular embodiment, inert graphite, a polymeric binder, and a solvent.

The polymeric binder in the inert conductive paste layer 23 generally provides a base material to secure the conductive material within the resulting device 10 and can act as an adhesive layer between the metal contact layer 24 and the p-type absorber layer 20. In one particular embodiment, the polymeric binder is a chlorinated polymeric binder or another halogenated polymer binder. The polymeric binder can generally include at least one organic polymer (i.e., containing a carbon backbone) or a combination of polymers forming a polymer system. As used herein, the term "polymer" generally includes, but is not limited to, homopolymers; copolymers, such as, for example, block, graft, random and alternating copolymers; and terpolymers; and blends and modifications thereof. Furthermore, unless otherwise specifically limited, the term "polymer" shall include all possible geometrical configurations of the material. These configurations include, but are not limited to isotactic, syndiotactic, and random symmetries.

The solvent system in the conductive paste can include at least one solvent that is configured to help apply the polymeric binder and/or the conductive material onto the surface 21 of the p-type absorber layer 20 during processing. As such, the particular solvent(s) can be selected based on the particular composition of the polymeric binder and/or the conductive material utilized in the conductive paste. The solvent can be substantially removed after applying the conductive paste to the surface 21 during subsequent processing (e.g,. during curing) such that the resulting device 10 is substantially free from the solvent. Suitable solvents can include, but are not limited to dimethyl succinate, dimethyl glutarate, or mixtures thereof. In one particular embodiment, the solvent system includes at least one chlorinated solvent.

The conductive paste can be applied onto the surface 21 of the p-type absorber layer 20 during processing of the device 10 by any suitable method for spreading the blend or paste, such as screen printing, spraying or by a "doctor" blade. After the application of the conductive paste to the p-type absorber layer 20, the conductive paste can be cured to convert the conductive paste into the inert conductive paste layer 23. Such a curing process can evaporate the solvent system present in the as-applied conductive paste and/or crosslink the polymeric binder to secure and/or bond the inert conductive paste layer 23 on the surface 21.

After the application of the conductive paste, the device 10 can be heated to convert the paste into the inert conductive paste layer 23 (e.g., an inert graphite layer). Such heating can anneal the paste and remove the solvent(s) from the resulting inert conductive paste layer 23. Each of the components (and any additional components) in the conductive paste can be selected such that, during and/or following annealing no acid or other chemical modifier is produced in any significant amount.

The inert conductive paste layer 23 can be, in particular embodiments, from about 0.1 µm to about 15 µm in thickness, for example from about 1 µm to about 8 µm (e.g., about 1 µm to about 5 µm or about 3 µm to about 8 µm).

The surface 21 of the p-type absorber layer 20 can be enriched with tellurium by any suitable methods. In one embodiment, for example, a copper source compound (e.g., a copper halide, a copper acetate, a copper-sulfur compound, or a mixture thereof) can be applied onto the exposed surface to form copper telluride. In an alternative embodiment, an iodine source compound can be applied onto the exposed surface 21. In yet another embodiment, the surface 21 of the p-type absorber layer 20 can be tellurium enriched via an ion-exchange reaction.

As stated, the back contact generally serves as the opposite electrical contact, in relation to the TCO layer 14 serving as the front electrical contact, and is formed from the inert conductive paste layer 23 and a metal contact layer 24, as is shown on the absorber layer 20. The back contact is formed on, and in one embodiment is in direct contact with, the surface 21 of the cadmium telluride layer 20.

Generally, the inert conductive paste layer 23 described above can be used in any cadmium telluride thin film photovoltaic device 10, such as the exemplary device 10 shown in Figs. 1-2. The exemplary device 10 of Figs. 1-2 includes a transparent substrate 12 of glass. In this embodiment, the glass 12 can be referred to as a "superstrate," since it is the substrate on which the subsequent layers are formed, but it faces upwards to the radiation source (e.g., the sun) when the cadmium telluride thin film photovoltaic device 10 is in used. The top sheet of glass 12 can be a high-transmission glass (e.g., high transmission borosilicate glass), low-iron float glass, or other highly transparent glass material. The glass is generally thick enough to provide support for the subsequent film layers (e.g., from about 0.5 mm to about 10 mm thick), and is substantially flat to provide a good surface for forming the subsequent film layers. In one embodiment, the glass 12 can be a low iron float glass containing less than about 0.15% by weight iron (Fe), and may have a transmission of about 90% or greater in the spectrum of interest (e.g., wavelengths from about 300 nm to about 900 nm).

The transparent conductive oxide (TCO) layer 14 is shown on the transparent substrate 12 of the exemplary device 10. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). The TCO layer 14 generally includes at least one conductive oxide, such as tin oxide, zinc oxide, or indium tin oxide, or mixtures thereof. Additionally, the TCO layer 14 can include other conductive, transparent materials. The TCO layer 14 can also include zinc stannate and/or cadmium stannate.

The TCO layer 14 can be formed by sputtering, chemical vapor deposition, spray pyrolysis, or any other suitable deposition method. In one particular embodiment, the TCO layer 14 can be formed by sputtering, either DC sputtering or RF sputtering, on the glass 12. For example, a cadmium stannate layer can be formed by sputtering a hot-pressed target containing stoichiometric amounts of SnO₂ and CdO onto the glass 12 in a ratio of about 1 to about 2. The cadmium stannate can alternatively be prepared by using cadmium acetate and tin (II) chloride precursors by spray pyrolysis.

In certain embodiments, the TCO layer 14 can have a thickness between about 0.1 µm and about 1 µm, for example from about 0.1 µm to about 0.5 µm, such as from about 0.25 µm to about 0.45 µm. Suitable flat glass substrates having a TCO layer 14 formed on the superstrate surface can be purchased commercially from various glass manufactures and suppliers. For example, a particularly suitable glass 12 including a TCO layer 14 includes a glass commercially available under the name TEC 15 TCO from Pilkington North America Inc. (Toledo, Ohio), which includes a TCO layer having a sheet resistance of 15 ohms per square.

The resistive transparent buffer layer 16 (RTB layer) is shown on the TCO layer 14 on the exemplary cadmium telluride thin film photovoltaic device 10. The RTB layer 16 is generally more resistive than the TCO layer 14 and can help protect the device 10 from chemical interactions between the TCO layer 14 and the subsequent layers during processing of the device 10. For example, in certain embodiments, the RTB layer 16 can have a sheet resistance that is greater than about 1000 ohms per square, such as from about 10 kOhms per square to about 1000 MOhms per square. The RTB layer 16 can also have a wide optical bandgap (e.g., greater than about 2.5 eV, such as from about 2.7 eV to about 3.0 eV).

Without wishing to be bound by a particular theory, it is believed that the presence of the RTB layer 16 between the TCO layer 14 and the cadmium sulfide layer 18 can allow for a relatively thin cadmium sulfide layer 18 to be included in the device 10 by reducing the possibility of interface defects (i.e., "pinholes" in the cadmium sulfide layer 18) creating shunts between the TCO layer 14 and the cadmium telluride layer 20. Thus, it is believed that the RTB layer 16 allows for improved adhesion and/or interaction between the TCO layer 14 and the cadmium telluride layer 20, thereby allowing a relatively thin cadmium sulfide layer 18 to be formed thereon without significant adverse effects that would otherwise result from such a relatively thin cadmium sulfide layer 18 formed directly on the TCO layer 14.

The RTB layer 16 can include, for instance, a combination of zinc oxide (ZnO) and tin oxide (SnO₂), which can be referred to as a zinc tin oxide layer ("ZTO"). In one particular embodiment, the RTB layer 16 can include more tin oxide than zinc oxide. For example, the RTB layer 16 can have a composition with a stoichiometric ratio of ZnO/SnO₂ between about 0.25 and about 3, such as in about an one to two (1:2) stoichiometric ratio of tin oxide to zinc oxide. The RTB layer 16 can be formed by sputtering, chemical vapor deposition, spraying pryolysis, or any other suitable deposition method. In one particular embodiment, the RTB layer 16 can be formed by sputtering, either DC sputtering or RF sputtering, on the TCO layer 14. For example, the RTB layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas). When the oxidizing atmosphere includes oxygen gas (i.e., O₂), the atmosphere can be greater than about 95% pure oxygen, such as greater than about 99%.

In certain embodiments, the RTB layer 16 can have a thickness between about 0.075 µm and about 1 µm, for example from about 0.1 µm to about 0.5 µm. In particular embodiments, the RTB layer 16 can have a thickness between about 0.08 µm and about 0.2 µm, for example from about 0.1 µm to about 0.15 µm.

The cadmium sulfide layer 18 is shown on resistive transparent buffer layer 16 of the exemplary device 10. The cadmium sulfide layer 18 is an n-type layer that generally includes cadmium sulfide (CdS) but may also include other materials, such as zinc sulfide, cadmium zinc sulfide, etc., and mixtures thereof as well as dopants and other impurities. In one particular embodiment, the cadmium sulfide layer may include oxygen up to about 25% by atomic percentage, for example from about 5% to about 20% by atomic percentage. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering, either direct current (DC) sputtering or radio frequency (RF) sputtering, on the resistive transparent layer 16. Sputtering deposition generally involves ejecting material from a target, which is the material source, and depositing the ejected material onto the substrate to form the film. DC sputtering generally involves applying a voltage to a metal target (i.e., the cathode) positioned near the substrate (i.e., the anode) within a sputtering chamber to form a direct-current discharge. The sputtering chamber can have a reactive atmosphere (e.g., an oxygen atmosphere, nitrogen atmosphere, fluorine atmosphere) that forms a plasma field between the metal target and the substrate. The pressure of the reactive atmosphere can be between about 1 mTorr and about 20 mTorr for magnetron sputtering. When metal atoms are released from the target upon application of the voltage, the metal atoms can react with the plasma and deposit onto the surface of the substrate. For example, when the atmosphere contains oxygen, the metal atoms released from the metal target can form a metallic oxide layer on the substrate. Conversely, RF sputtering generally involves exciting a capacitive discharge by applying an alternating-current (AC) or radio-frequency (RF) signal between the target (e.g., a ceramic source material) and the substrate. The sputtering chamber can have an inert atmosphere (e.g., an argon atmosphere) having a pressure between about 1 mTorr and about 20 mTorr.

Due to the presence of the resistive transparent layer 16, the cadmium sulfide layer 18 can have a thickness that is less than about 0.1 µm, such as between about 10 nm and about 100 nm, such as from about 40 nm to about 80 nm, with a minimal presence of pinholes between the resistive transparent layer 16 and the cadmium sulfide layer 18. Additionally, a cadmium sulfide layer 18 having a thickness less than about 0.1 µm reduces any adsorption of radiation energy by the cadmium sulfide layer 18, effectively increasing the amount of radiation energy reaching the underlying cadmium telluride layer 20.

The cadmium telluride layer 20 is shown on the cadmium sulfide layer 18 in the exemplary cadmium telluride thin film photovoltaic device 10 of Fig. 1. The cadmium telluride layer 20 is a p-type absorber layer that generally includes cadmium telluride (CdTe) but may also include other materials. As the p-type absorber layer of device 10, the cadmium telluride layer 20 is the photovoltaic layer that interacts with the cadmium sulfide layer 18 (i.e., the n-type layer) to produce current from the adsorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the cadmium telluride layer 20) across the junction to the n-type side (i.e., the cadmium sulfide layer 18) and, conversely, holes may pass from the n-type side to the p-type side. Thus, the p-n junction formed between the cadmium sulfide layer 18 and the cadmium telluride layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 µm and about 10 µm, such as from about 1 µm and about 5 µm. In one particular embodiment, the cadmium telluride layer 20 can have a thickness between about 2 µm and about 4 µm, such as about 3 µm.

A series of post-forming treatments can be applied to the exposed surface of the cadmium telluride layer 20. These treatments can tailor the functionality of the cadmium telluride layer 20 and prepare its surface for subsequent adhesion to the back contact layers, particularly the inert conductive paste layer 23. For example, the cadmium telluride layer 20 can be annealed at elevated temperatures (e.g., from about 350° C to about 500° C, such as from about 375° C to about 424° C) for a sufficient time (e.g., from about 1 to about 10 minutes) to create a quality p-type absorber layer of cadmium telluride. Without wishing to be bound by theory, it is believed that annealing the cadmium telluride layer 20 (and the device 10) converts the weakly p-type cadmium telluride layer 20 to a more strongly p-type cadmium telluride layer 20 having a relatively low resistivity. Additionally, the cadmium telluride layer 20 can recrystallize and undergo grain growth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride then annealed at the elevated temperature.

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing oxides from the surface, such as CdO, CdTeO_{3,} CdTe₂O₅ etc. For instance, the surface can be washed with a suitable solvent (e.g., ethylenediamine also known as 1,2 diaminoethane or "DAE") to remove any cadmium oxide from the surface. In one embodiment, the application of the treatment solution described above, and its subsequent annealing, can be performed after annealing the cadmium telluride layer 20 in the presence of cadmium chloride and washing the surface 21.

As stated, the back contact is formed from the inert conductive paste layer 23 and the metal contact layer 24 shown on the Te-enriched region 22 of the cadmium telluride layer 20. The inert conductive paste layer 23 generally serves as the back electrical contact, in relation to the opposite, TCO layer 14 serving as the front electrical contact. The back contact is formed on, and in one embodiment is in direct contact with, the Te-enriched region 22 of the cadmium telluride layer 20. The metal contact layer 24 is suitably made from one or more highly conductive materials, such as elemental nickel, chromium, copper, molybdenum, tin, aluminum, gold, silver, technetium or alloys or mixtures thereof. The metal contact layer 24, if made of or comprising one or more metals, is suitably applied by a technique such as sputtering or metal evaporation. The metal contact layer 24 can be from about 0.1 µm to about 1.5 µm in thickness.

Other layers may also be present in the thin film stack, although not specifically shown in the embodiment of Figs. 1 and 2. For example, index matching layers may be present between the transparent conductive oxide layer 14 and the superstrate 12. Additionally, an oxygen getter layer may be present in the thin film stack, such as adjacent to the transparent conductive oxide layer 14 (e.g., between the transparent conductive oxide layer 14 and the optional resistive transparent buffer layer 16).

Other components (not shown) can be included in the exemplary device 10, such as buss bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor such as a wire or bus bar, to direct the photovoltaically generated current to convenient locations for connection to a device or other system using the generated electric. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells, as described above with respect to Fig. 1.

An encapsulating substrate 25 is laminated to the transparent substrate 12 to complete the device 10.

Methods for forming a photovoltaic device are also generally provided.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A photovoltaic device, comprising:
   a transparent superstrate;
   a transparent conductive oxide on the transparent superstrate;
   an n-type window layer on the transparent superstrate;
   a p-type absorber layer on the n-type window layer, wherein the p-type absorber layer comprising cadmium telluride, wherein the p-type absorber layer defines a back surface positioned opposite from the n-type window layer, and wherein the back surface is tellurium enriched; and,
   an inert conductive paste layer on the back surface of the p-type absorber layer, wherein the inert conductive paste layer is substantially free from an acid or acid generator.
2. The device as in clause 1, further comprising:
   a metal layer on the inert conductive paste layer.
3. The device as in any preceding clause, wherein the metal layer comprises elemental nickel, chromium, copper, molybdenum, tin, aluminum, gold, silver, technetium, or alloys or mixtures thereof.
4. The device as in any preceding clause, wherein the inert conductive paste layer is formed from a conductive paste.
5. The device as in any preceding clause, wherein the inert conductive paste layer comprises a graphite and a polymeric binder.
6. The device as in any preceding clause, wherein the polymeric binder comprises a chlorinated polymeric binder.
7. The device as in any preceding clause, wherein the back surface of the p-type absorber layer comprises copper telluride.
8. The device as in any preceding clause, wherein the back surface of the p-type absorber layer comprises iodine.
9. The device as in any preceding clause, wherein the inert conductive paste layer fills any pinholes defined in the p-type absorber layer.
10. A method of forming a back contact onto an exposed surface of a p-type absorber layer of a p-n junction in the manufacture of a thin film photovoltaic device, wherein the p-type absorber layer comprises cadmium telluride, the method comprising:
   enriching the exposed surface with tellurium;
   forming an inert conductive paste layer onto the exposed surface; and,
   applying a metal layer onto the inert conductive paste layer.
11. The method as in any preceding clause, wherein the metal layer comprises elemental nickel, chromium, copper, molybdenum, tin, aluminum, gold, silver, technetium, or alloys or mixtures thereof.
12. The method as in any preceding clause, wherein forming the inert conductive paste layer comprises:
   applying a conductive paste onto the exposed surface of the p-type absorber layer; and,
   annealing the conductive paste to form the inert conductive paste layer.
13. The method as in any preceding clause, wherein the conductive paste comprises graphite, a polymeric binder, and a solvent.
14. The method as in any preceding clause, wherein the conductive paste does not form any acid during annealing.
15. The method as in any preceding clause, wherein enriching the exposed surface of the p-type absorber layer comprises applying a copper source compound onto the exposed surface to form copper telluride.
16. The method as in any preceding clause, wherein the copper-containing metal salt comprises a copper halide, a copper acetate, a copper-sulfur compound, or a mixture thereof.
17. The method as in any preceding clause, wherein enriching the exposed surface of the p-type absorber layer comprises applying an iodine source compound onto the exposed surface.
18. The method as in any preceding clause, wherein the enriching the exposed surface of the p-type absorber layer is achieved via an ion-exchange reaction.
19. The method as in any preceding clause, wherein the inert conductive paste layer fills any pinholes defined in the p-type absorber layer.

## Claims

1. A photovoltaic device (10), comprising:
a transparent superstrate (12);
a transparent conductive oxide (14) on the transparent superstrate;
an n-type window layer (18) on the transparent superstrate;
a p-type absorber layer (20) on the n-type window layer (18), wherein the p-type absorber layer (20) comprising cadmium telluride, wherein the p-type absorber layer (20) defines a back surface positioned opposite from the n-type window layer (18), and wherein the back surface is tellurium enriched; and,
an inert conductive paste layer (23) on the back surface of the p-type absorber layer (20), wherein the inert conductive paste layer (23) is substantially free from an acid or acid generator.

2. The device as in claim 1, further comprising:
a metal layer (24) on the inert conductive paste layer (23).

3. The device as in claim 1 or claim 2, wherein the metal layer (24) comprises elemental nickel, chromium, copper, molybdenum, tin, aluminum, gold, silver, technetium, or alloys or mixtures thereof.

4. The device as in claim 1, 2 or 3, wherein the inert conductive paste layer (23) is formed from a conductive paste.

5. The device as in any preceding claim, wherein the inert conductive paste layer (23) comprises a graphite and a polymeric binder, and, preferably, the polymeric binder comprises a chlorinated polymeric binder.

6. The device as in any preceding claim, wherein the back surface of the p-type absorber layer (20) comprises copper telluride or iodine.

7. The device as in any preceding claim, wherein the inert conductive paste layer (23) fills any pinholes defined in the p-type absorber layer (20).

8. A method of forming a back contact onto an exposed surface of a p-type absorber layer (20) of a p-n junction in the manufacture of a thin film photovoltaic device, wherein the p-type absorber layer (20) comprises cadmium telluride, the method comprising:
enriching the exposed surface with tellurium;
forming an inert conductive paste layer (23) onto the exposed surface; and,
applying a metal layer (24) onto the inert conductive paste layer (23).

9. The method as in claim 8, wherein the metal layer (24) comprises elemental nickel, chromium, copper, molybdenum, tin, aluminum, gold, silver, technetium, or alloys or mixtures thereof.

10. The method as in claim 8 or claim 9, wherein forming the inert conductive paste layer (23) comprises:
applying a conductive paste onto the exposed surface of the p-type absorber layer (20); and,
annealing the conductive paste to form the inert conductive paste layer (23).

11. The method as in claim 10, wherein the conductive paste comprises graphite, a polymeric binder, and a solvent.

12. The method as in claim 10 or claim 11, wherein the conductive paste does not form any acid during annealing.

13. The method as in any one of claims 8 to 12, wherein enriching the exposed surface of the p-type absorber layer (20) comprises applying a copper source compound onto the exposed surface to form copper telluride, wherein the copper-containing metal salt preferably comprises a copper halide, a copper acetate, a copper-sulfur compound, or a mixture thereof.

14. The method as in any one of claims 8 to 13, wherein enriching the exposed surface of the p-type absorber layer (20) comprises applying an iodine source compound onto the exposed surface, or is achieved via an ion-exchange reaction.

15. The method as in any one of claims 8 to 14, wherein the inert conductive paste layer (23) fills any pinholes defined in the p-type absorber layer (20).
